# EUROPEAN PATENT SPECIFICATION

(11) **EP 0 873 590 B1**
(45) Date of publication and mention of the grant of the patent: **21.05.2003**
(21) Application number: 96946123.5
(22) Date of filing: 20.12.1996
(51) Int. Cl.: H03H 9/17, H03H 9/02

(54) **HIGH FREQUENCY SAW DEVICE**
HOCHFREQUENZ-SAW-VORRICHTUNG
DISPOSITIF A ONDES ACOUSTIQUES DE SURFACE HAUTE FREQUENCE

(30) Priority: 10.01.1996 RU 96100012
(43) Date of publication of application: 28.10.1998
(60) Divisional application: 00106913.7
(73) Proprietor: Sawtek, Inc., Orlando, FL 32860-9501 (US)
(72) Inventor: NAUMENKO, Natalya F., Moscow, 115569 (RU); ORLOV, Victor S., Moscow, 115569 (RU)
(74) Representative: Holmes, Miles Keeton
(86) International application number: PCT/US96/17906
(87) International publication number: WO 97/025776

(56) References cited:
- PROCEEDINGS OF THE 1994 IEEE INTERNATIONAL FREQUENCY CONTROL SYMPOSIUM (THE 48TH ANNUAL SYMPOSIUM) (CAT. NO.94CH3446-2), PROCEEDINGS OF IEEE 48TH ANNUAL SYMPOSIUM ON FREQUENCY CONTROL, BOSTON, MA, USA, 1-3 JUNE 1994, ISBN 0-7803-1945-1, 1994, NEW YORK, NY, USA, IEEE, USA, pages 43-47, XP000674152 DUBOVIK M F ET AL: "Langasite (La/sub 3/Ga/sub 5/SiO/sub 14/) an optical piezoelectric: growth and properties"
- 1995 IEEE ULTRASONICS SYMPOSIUM. PROCEEDINGS. AN INTERNATIONAL SYMPOSIUM (CAT. NO.95CH35844), 1995 IEEE ULTRASONICS SYMPOSIUM. PROCEEDINGS. AN INTERNATIONAL SYMPOSIUM, SEATTLE, WA, USA, 7-10 NOV. 1995, ISBN 0-7803-2940-6, 1995, NEW YORK, NY, USA, IEEE, USA, pages 197-200 vol.1, XP000674153 KOZLOV A I: "Quasilongitudinal pseudosurface acoustic waves in trigonal crystals"
- YAKOVKIN I.B. ET AL: 'Numerical and Experimental Investigation in Langasite' 1995 IEEE ULTRASONICS SYMPOSIUM 07 November 1995, NEW YORK, NY, USA, pages 389 - 392

## Description

### Field of the Invention

The invention relates to a surface acoustic wave (SAW) device and, more particularly, to a device having a langasite crystal substrate with a predetermined crystalline orientation for causing a surface acoustic wave to propagate along a predetermined crystalline axis of the substrate.

### Background of the Invention

This invention relates to an optimal surface acoustic wave orientation on single crystal lanthanum gallium silicate or La₃ Ga₅ Si O₁₄, commonly known as langasite (LSG). SAW devices are currently used a bandpass filters, resonators, delay lines, convolvers, etc. in a broad range of RF and IF applications such as wireless, cellular communication and cable TV. Three commonly used substrates are lithium niobate, ST-quartz, and lithium tantalate. There are several material properties that determine the usefulness of any particular crystal and, in particular, orientation of a particular crystal. These properties include: 1) SAW velocity, Vs; 2) the SAW piezoelectric coupling coefficient, k²; 3) the power flow angle, PFA; 4) the diffraction or beam spreading coefficient, γ (gama); and 5) the temperature coefficient of delay, TCD. It has not been possible to find an orientation in any existing substrate which optimizes these properties at the same time; so the choice of substrate and orientation depends upon what is important for the application, and almost always involves a compromise between the SAW material properties. A high velocity is desirable for high frequency devices, because the device geometry patters are larger and, therefore, the devices are easier to fabricate. At low frequencies, a low velocity is usually desirable because the device size is smaller, resulting in lower devices and packaging costs. Thus, there is no universally optimum velocity. For moderate to wide bandwidth devices, a high value of k² is desirable because it allows lower insertion loss. From the point of view of k², lithium niobate is best, quartz is worst, and lithium tantalate is in between. For most devices, and in particular narrow band devices, TCD should be as low as possible and ideally zero. From this point of view, ST-quartz is best, lithium niobate is worst, and lithium tantalate is in between (just the opposite ranking as for k²). The optimum value of γ is -1, which results in minimum beam spreading. From this point of view, YZ lithium niobate is now ideal, ST-quartz is worst, and lithium tantalate is in between. The PFA should be zero, and this is the case for most of the commonly used SAW substrates, with an exception being 112° lithium tantalate, which has a PFA of 1.55°. For the most narrow band applications, ST-quartz is a quite acceptable choice; and for the very wide band applications where temperature stability is not so important (*e.g.*, a device can be held at constant temperatures), lithium niobate is usually quite acceptable. What is needed is a substrate orientation that offers the temperature stability of ST-quartz but with higher k² and at the same time low or zero beam steering (PFA) and diffraction (γ = -1). We have a substrate that meets these conditions.

A SAW device is known which contains a piezoelectric substrate with input and output interdigital transducers (IDT's) on its surface. ST quartz is used to achieve the better temperature stability. The orientation of ST-cut with respect to crystallographic axes is described by Euler angles φ = 0°, θ = 132.75°, and ψ = 0°. For this cut, the temperature coefficient is equal to zero.

The known device has a disadvantage of high insertion loss due to transduction loss because of a low electromechanical coefficient kₛ² = 0.116%, and propagation loss in high frequency range (more than 3.1 dB/µs at frequency 1 GHz). This results in an increased insertion loss of devices and makes it impossible to use them in mobile communication systems. The insertion loss of filters for mobile communications must not exceed 3-4 dB at intermediate radio-frequencies 800-1800 MHZ.

I B YAKOVKIN ET AL: "Numerical and Experimental Investigation in Langasite" IEEE ULTRASONICS SYMPOSIUM, US, IEEE, NEW YORK, NY, 7 November 1995 (1995-11-07), pages 389-392-392, XP002112466 discloses some numerical modelling of SAW in a langasite substrate. The paper includes a table indicating some of the "extreme characteristics" of SAW. These include a maximum K²/2 (where K² is the phase velocity) for which the Euler angles are stated as being 0,147,22 indicated by way of example. This paper discusses shear piezoactive parameters for cut angles, which shear is for bulk wave devices rather than SAW devices.

### SUMMARY OF THE INVENTION

The invention as claimed in claim 1 appended hereto is a surface acoustic wave (S.A.W.) device.

The use of the langasite offers a decreased propagation loss as compared to quartz (up to 1 dB/µs at the frequency 1 GHZ). To reduce the transduction loss, the Euler angles, which define the orientation of the substrate are chosen as follows: φ = 90°. θ = 10°. and ψ = 0°.

The following disadvantages in the known devices include bad temperature stability (the temperature coefficient = 12 10⁻⁶) and high transduction loss, high beam steering loss, and high diffraction loss, defined by electromechanical coupling kₛ², PFA and anisotropy parameter, respectively For the mentioned device, kₛ² = 0.25%, φ = -5.7%, and γ = -2.859%.

The present invention is directed toward reducing insertion loss and improving temperature stability.

This purpose is achieved as follows: the surface of the langasite substrate is perpendicular to axis Z', electrodes of IDTs are perpendicular to axis X' and are parallel to axis Y'. Axes X', Y', Z' are defined by Euler angles with respect to crystallographic axes X, Y, Z of langasite - angle φ is in the range -15° to 10°, angle θ in the range of 120° to 165°, and angle ψ in the range of 20° to 45°.

### BRIEF DESCRIPTION OF THE DRAWINGS

FIG. 1 diagrammatically illustrates substrate axes X', Y', and Z' and crystal axes X, Y, and Z along with Euler angles describing relative orientation of X,Y, and Z to X', Y', and Z';
FIG. 2 is a perspective view of a SAW device illustrating interdigital transducers located on a langasite substrate surface;
FIG. 3 illustrates SAW parameters (Velocity, Power Flow Angle, Electromechanical Coupling Coefficient, and Temperature Coefficient) versus propagation angle ψfor different values of θ; and
FIG. 4 illustrates SAW parameters of FIG. 3 versus ψ for θ=145° for different values of φ.

### DESCRIPTION OF THE PREFERRED EMBODIMENT

The crystal cut of langasite with Euler angles φ = -1%, θ= 135.6° +/-10%, and ψ = 24.1° +/- 8°, provide improved performance for SAW devices. Specifically, the crystal cut provides a near simultaneous optimization of three critical SAW propagation parameters and a favorably value of a fourth parameter. This fourth parameter is the coupling constant k², which varies between 0.25 and 0.35% as compared to .12% for ST-quartz crystal. The three SAW propagation parameters are PFA, γ and TCD, which are the power flow angle, the diffraction coefficient, and the temperature coefficient delay, respectively. PFA is also known as the beam steering angle and is the angle between the SAW wave vector, which is always normal to the tap electrodes, and the direction of the power flow. Ideally, PFA should be zero. γ is a measure of the diffraction or beam spreading. Normally, as a SAW propagates on a substrate, the beam profile will change and broaden. This beam spread causes diffraction loss and distortion to the filter response. For isotropic materials, the value of γ is zero, and diffraction is a moderately serious problem. Diffraction is minimized when γ = -1, and this is the case for YZ Li Nb O₃ and a special MDC (minimum diffraction cut) of Li Ta O₃. For ST-quartz, γ = +.38, and diffraction is worse than the isotropic case. There is a range of angle within the designated range of this disclosure for which γ = -1, which is ideal. Likewise there is a range of angles for which the TCD is zero. (TCD is the relative change in delay per degree centigrade.) The ideal parameter values are obtained for each parameter within the restricted range of angles of this disclosure; but since the angles associated with the values form a locus of points in a two-dimensional angle space (over θ and ψ), there is no point at which the three loci intersect. That means it is possible to achieve ideal performance in two of the three parameters but not all three parameters. Therefore, within this range, the optimal choice of angles would still be dependent upon the application, and in fact are intermediate points that minimize the problem of all three parameters. This is the reason for the spread of angles in this disclosure.

There sometimes is confusion about the use of Euler angles so a verbal description is appropriate.

Consider a wafer outline on a surface normal to the axis Z'. Now construct a flat along one edge of the wafer normal to the axis X'. The direction of SAW propagation is parallel to axis X'. Now assume that the crystal axes X, Y, Z are coincident with the wafer outline axes X', Y', Z', respectively. With no rotation, the wafer is considered Z cut (the wafer is cut with the polished surface normal to Z) and X propagating (the SAW propagates in a direction parallel to the X axis). With any subsequent rotation, the wafer axes X', Y', Z' are rotated, and the crystal axes X, Y, Z are assumed to be fixed. Now, by way of example, consider the Euler angles (φ, θ, ψ) = (0°, 135°; 28°), which is a case near the middle of the designated range. The first rotation would rotate around Z' (X' toward Y') by φ. Since φ = 0°, there is no rotation for this case. The next rotation is around the "new" X' (the "new" axes are always tied to the wafer so that any rotation is around a wafer axis that includes all previous rotations) by θ (which is 135°) (Y' toward Z' for a positive angle rotation). Finally, rotate around Z' (X' toward Y') by ψ, which in this case is 28°.

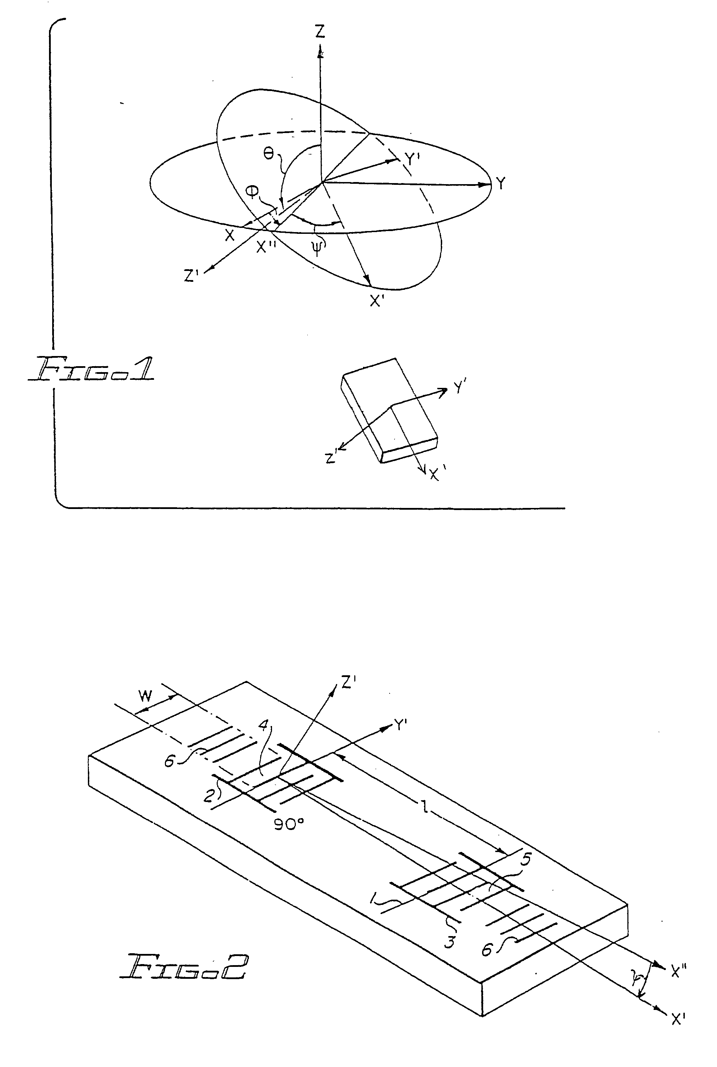

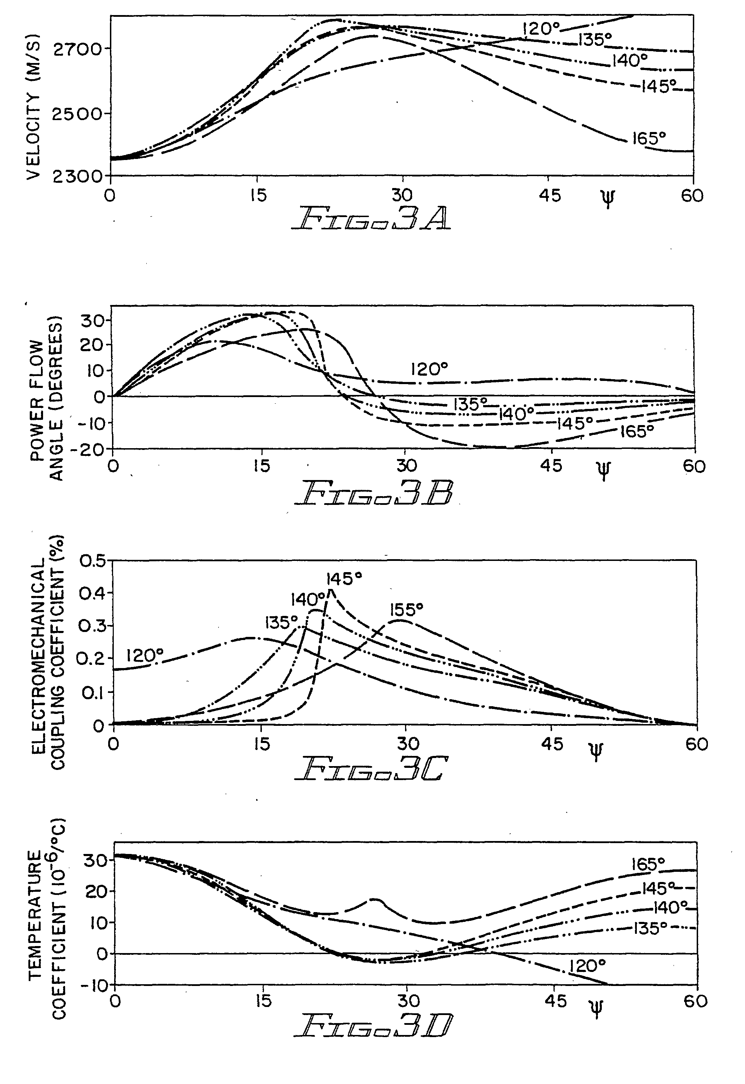

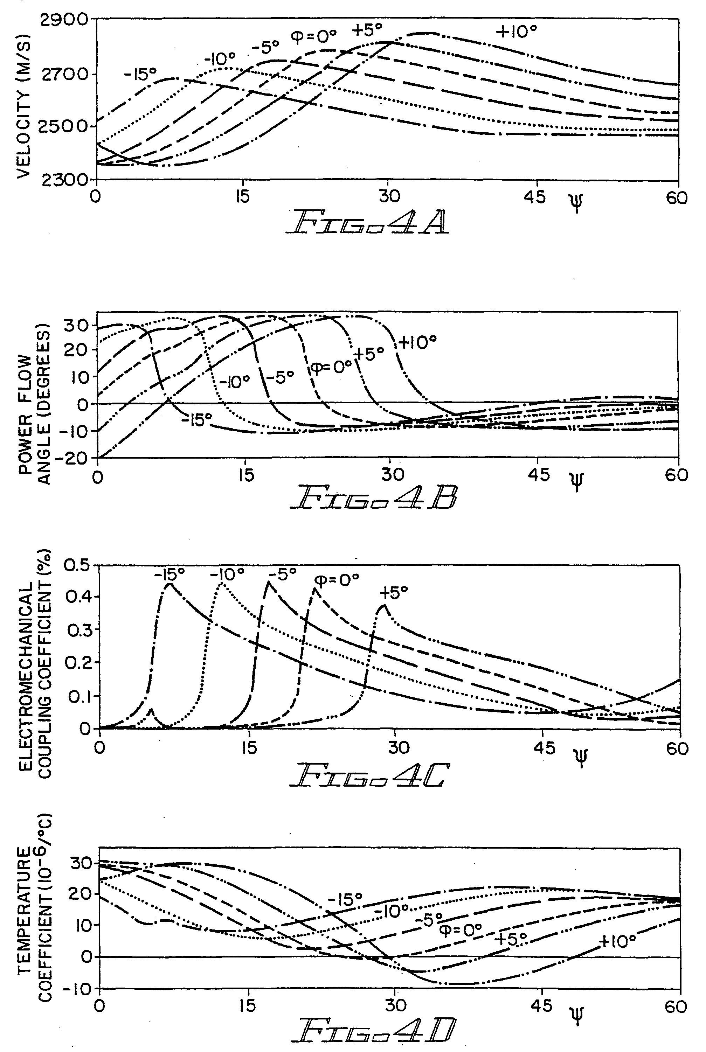

A high frequency SAW device is described with reference to FIGS. 1 and 2. FIG. 3 illustrates SAW velocity, PFA, electromechanical coupling kₛ² and temperature coefficient versus Euler angle ψ for some values of angle θ and for φ = 0°. Velocity, φ, kₛ and temperature coefficient versus ψ for some value of φ and for θ = 145° are illustrated in FIG. 4.

A preferred embodiment of the present invention includes a SAW device containing a langasite substrate (1), and IDT's (2), (3) and reflecting electrodes (6), if necessary. The normal Z' to the substrate surface, the normal X' to electrodes 4, 5, 6, by way of the example illustrated, and axis Y' (parallel to electrodes) are defined with respect to crystallographic axes as follows: φ = -15° to 10°; θ = = 120° to 165°, ψ = 20° to 45°, where φ, θ, ψ are Euler angles.

φ is the angle between crystallographic axis X and auxiliary axis X", which is the axis of rotation of the plane XY (up to required orientation of the substrate surface).

θ is the angle between axis Z and the normal Z' to the substrate surface (1).

ψ is the angle between axis X" and axis X', X' is perpendicular to electrodes of IDT's (2), (3).

The SAW device operates as follows. When a voltage is applied to IDT (2), the surface acoustic wave is generated in the substrate and the energy flow propagates in the direction X' (the angle between X" and X' is equal to ψ). SAW is detected by the output IDT and converted into the output voltage. The insertion loss of the SAW device results from a number of factors (bidirectionality is not considered here): transduction loss aₜ = aₜ₁ + aₜ₂ of the input and output IDT, defined by the electromechanical coupling propagation loss aₚ in the substrate, diffraction loss a_{d}, beam steering loss aₒ.

Therefore the insertion loss is defined as follows:${\text{a}}_{\text{L}} {\text{= a}}_{\text{T1}} {\text{+ a}}_{\text{T2}} {\text{+ a}}_{\text{p}} {\text{+ a}}_{\text{d}} {\text{+ a}}_{\text{0}} \text{, dB}$

Each component of the insertion loss depends on electrophysic parameters of the substrate and the geometric parameters of IDT's.

The transduction insertion loss a_{Ti} is inverse to the electromechanical coupling coefficient for an IDT with N pairs of electrodes matched by an inductor at the central frequency:${\text{a}}_{\text{Ti}} {\text{= -10 Ig [2b/(1 + b)}}^{\text{2}} \text{], dB}$ where b = G₀/Gₐ; G₀ - load conductance; Gₐ - IDT admittance. For example, the admittance of an unapodized IDT at the central frequency f₀ is defined as:${\text{G}}_{\text{a}} {\text{= 8 k}}_{\text{s}} {\text{}}^{\text{2}} {\text{f}}_{\text{0}} {\text{C}}_{\text{s}} {\text{N}}^{\text{2}} \text{W}$ where Cₛ = 2 (∈^{T}ₚᵣ + 1) (6.5) dₙ² + 1.08 dₙ + 2.37) 10⁻¹²; F/m - capacitance of an electrode pair of unit length; ∈^{T}ₚᵣ - dialectic permitivity; W - aperture; N - number of electrode pairs, which is defined by the specified band width as follows: N = 0.632 (Δf₋₃/f₀), where (Δf₋₃) normalized 3dB-bandwidth.

The propagation loss is proportional to the distance between input and output IDT:${\text{a}}_{\text{p}} {\text{= bf}}^{\text{2}} \text{+ df, dB/µsec,}$ where b,c - constants of the substrate material; f - operating frequency, GHz.

The beam steering loss is proportional to angle :${\text{a}}_{\text{0}} \text{= -20 Ig (1 - B tg φ), dB}$ where B-geometrical parameter, which is equal to l/w; I-distance between IDT centers; W - aperture.

The diffraction loss in the Fresnel region is defined as follows [4]: 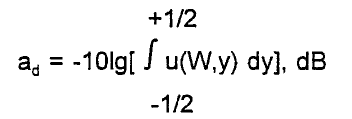 where${\text{Re u(W,y) = Ci(α}}_{\text{1}} {\text{) - Ci(α}}_{\text{2}} \text{),}$${\text{Im u(W,y) - Si(α}}_{\text{2}} {\text{) - Si(α}}_{\text{1}} \text{),}$${\text{a}}_{\text{1}} {\text{= π W}}^{\text{2}} {\text{(y + 1/2)}}^{\text{2}} \text{/[ | 1+γ | 1λ],}$${\text{a}}_{\text{2}} {\text{= π W}}^{\text{2}} {\text{(y - 1/2)}}^{\text{2}} \text{/[ | 1+γ | 1λ],}$ Cᵢ(α) and Sᵢ(α) Fresnel integrals; γ-anisotropy parameter of the substrate material in the propagation direction; λ - wavelength. Diffraction loss depends on the sign and value of γ and is minimum if γ = -1, which corresponds to cuts with auto-collimation.

Thus, the insertion loss in a device can be reduced by choosing an orientation of a substrate with high electromechanical coupling, low beam steering angle, anistropy parameter (close to -1). For typical value for IDT aperture, W = (20-80)λ and the distance between input and output transducers I = (200-300)λ, the diffraction loss is related to the distortion of the form of acoustic beam and does not exceed 1.6 dB [1]. Therefore the insertion loss of the device mostly depends on transduction loss and beam steering loss.

Let us estimate advantages of the proposed device as compared to the known on [2].

The SAW propagation parameters of the device-prototype with orientation (90°, 10°, 0°) are as follows: temperature coefficient = 12 10⁻⁶(1/°C), kₛ² = 0.26%, PFA= -5.7°.

As it is shown in FIGS. 3 and 4 in the proposed device based on langasite for any Euler angles within chosen limits -15°≤φ≤10°, 120°≤θ≤165°, 20°≤ψ≤45°, the temperature coefficient does not exceed 10 10⁻⁶(1/°^C and for orientation (0°, 144°, 22,75°) it is close to zero.

As a consequence, the temperature stability is improved as compared to the known device.

It is shown in FIGS. 3 and 4 that in the proposed device, the PFA is less than 5° and the electromechanical coupling coefficient is more than 0.2% with the maximum value 0.45%. Consequently on the most part of the proposed orientations, the electromechanical coupling coefficient kₛ is more than that in the device and the angle φ is less than that of the device. This results in the decreased transduction and beam steering loss. In some cases for 80° ≤ψ≤45°, kₛ² is somewhat less than that of the prototype (0.2%<kₛ²<0.26%) which is compensated by decreasing beam steering loss.

Therefore for any value of each Euler angle within the proposed group of orientation it is always possible to find such values of two other angles that their combination provides the improved temperature and stability and the decreased insertion loss as compared to the prototype.

Therefore, the desired result is achieved in the proposed device.

Consider, by way of example, a filter for wireless radiotelephones (European standard DECT) for intermediate frequency f₀ = 110.6 Mhz with a bandwidth Δf₀₋₃ = 0.965 Mhz or (Δf₋₃/f₀) = 0.88%. The langasite substrate is used with orientation defined by Euler angles (0°,146°, 22.5°) and the following parameters: kₛ² = 0.42%, PFA- 0.9°, temperature coefficient = 2 10⁻⁶ (1/°C). With the number of electrodes of each IDT close to the optimal value N = 72 (which provides minimum transduction loss if the load resistance is 50 ohms, aperture W = 3.5 and the distance between IDT's I = 10mm), the transduction loss of the proposed device is near zero (bidirectionality is not considered) and the beam steering loss is 0.4 dB.

For a device with similar geometric parameters, the values of transduction and beam steering loss are 0.6 dB and 2.9 dB, respectively. Then the gain in the insertion loss is 3.1 dB. Furthermore, the temperature stability is considerably better than that of the prototype.

By way of further example, consider a high frequency filter for the selection of carrier radio-frequencies in wireless radiotelephones (European standard DECT). The operating frequency is f₀ = 1,89 GHz, the bandwidth Δf₋₃ = 20 MHz or (Δf₋₃/f₀) ≈ 1%. For N = 65, a typical aperture W = 0.14 mm (100λ) the distance between IDT's centers I = 1mm and the substrate orientation defined by Euler angles (0°, 144°, 22.75°) with parameters: kₛ² ≈ 0.37, PFA ≈ 0°, temperature coefficient ≈ 0 (1/°C), the beam steering loss is zero and the transduction loss is 1.2 dB (the bidirectionality is not considered).

For the device with similar geometric parameters, the beam steering and transduction loss are 2.6 dB and 10.8 dB, respectively. The gain in the insertion loss is 12.2 dB. Moreover, the temperature stability is improved.

It is worth noting that earlier mentioned low-loss filters cannot be designed based on ST quartz.

While specific embodiments of the invention have been described in detail herein above, it is to be understood that various modifications may be made from the specific details described herein without departing from the scope of the invention as set forth in the appended claims.

Having now described the invention, the construction, the operation and use of preferred embodiments thereof, and the advantageous new and useful results obtained thereby, the new and useful constructions, methods of use and reasonable mechanical equivalents thereof obvious to those skilled in the art, are set forth in the appended claims.

## Claims

1. A high frequency surface acoustic wave (SAW) device comprising a lanthanum gallium silicate (langasite) substrate having input and output interdigital transducers (2, 3) on a surface thereof for launching and detecting surface acoustic waves wherein a surface wave direction of propagation is along an X' axis, the substrate further having a Z' axis normal to the surface and a Y' axis along the surface and perpendicular to the X' axis, and wherein the substrate is **characterised by**:
a crystallographic orientation of axes X', Y', Z' being defined by Euler angles (φ,θ,ψ) with angle φ ranging from -15° to + 10°, angle θ ranging from 120° to 165°, and angle ψ ranging from 20° to 45°, the Power Flow Angle (PFA) of the device being less than 5°, the electromechamical coupling coefficent being greater than 0.2% and the temperature coefficient not exceeding 10 x 10⁻⁶ per °C.

2. The high frequency surface acoustic wave device according to Claim 1, wherein said substrate has a diffraction coefficient (γ) having a valve equal to -1.

## Patentansprüche

1. Akustische Hochfrequenz-Oberflächenwellenvorrichtung (SAW), die ein Lanthangalliumsilicat- (Langasit-) Substrat aufweist mit Ineinandergreifenden Eingangs- und Ausgangswandlern (2, 3) auf einer Oberfläche für das Starten und Erfassen von akustischen Oberflächenwellen, wobei eine Ausbreitungsrichtung der Oberflächenwelle entlang einer X'-Achse ist, wobei das Substrat weiterhin eine Z'-Achse hat, die senkrecht auf der Oberfläche steht und eine Y'-Achse hat entlang der Oberfläche und senkrecht zu der X'-Achse und wobei das Substrat charakterisiert ist durch:
eine kristallographlsche Orientierung der Achsen X', Y', Z', die durch Eulerwinkel (*φ*,θ,ψ) definiert werden mit einem Winkel φ, der von -15° bis +10° reicht, einem Winkel θ, der von 120° bis 165° reicht und einem Winkel ψ. der von 20° bis 45° reicht, wobel der Leistungsflußwinkel (PFA) der Vorrichtung geringer als 5° ist, wobei der elektromechanische Kopplungskoeffizient größer als 0,2% ist und der Temperaturkoeffizient 10 x 10⁻⁶ pro °C nicht überschreitet.

2. Akustische Hochfrequenz-Oberflächenwellenvorrichtung nach Anspruch 1, wobei das Substrat einen Beugungskoeffizienten γ mit einem Wert gleich -1 hat

## Revendications

1. Dispositif à ondes acoustiques de surface (S.A.W.) à haute fréquence comportant un substrat (1) en silicate de lanthane et de gallium (langasite) ayant des transducteurs interdigités (2,3) d'entrée et de sortie sur la surface pour lancer et détecter des ondes acoustiques de surface, dans lequel une direction de propagation des ondes de surface suit un axe X', le substrat ayant en outre un axe Z' normal à la surface, et un axe Y' le long de la surface et perpendiculaire à l'axe X', le substrat étant **caractérisé en ce que** : une orientation cristallographique des axes X', Y' et Z' étant définie par des angles d'Euler (φ, θ, ψ), φ ayant une valeur allant de -15° à +10°, θ ayant une valeur allant de 120° à 165°, et ψ ayant une valeur allant de 20° à 45°, l'angle de flux d'énergie (PFA) du dispositif étant inférieur à 5°, le coefficient de couplage électro-mécanique étant supérieur à 0,2 % et le coefficient de température ne dépassant pas 10 x 10⁻⁶ par °C.

2. Dispositif à ondes acoustiques de surface à haute fréquence selon la revendication 1, dans lequel ledit substrat a un coefficient de diffraction (γ) égal à -1.
